# DEMANDE DE BREVET EUROPEEN

(11) **EP 3 697 187 A1**
(43) Date de publication de la demande: **19.08.2020**
(21) Numéro de dépôt: 20157059.5
(22) Date de dépôt: 13.02.2020
(51) Int. Cl.: H05K 13/02

(54) **PROCÉDÉ DE CAMBRAGE DES BROCHES ÉLECTRIQUES DE COMPOSANTS**

(30) Priorité: 14.02.2019 FR 1901493
(71) Demandeur: MGA Technologies, 69380 Civrieux d'Azergues (FR)
(72) Inventeur: de MALLIARD, Hervé, 69160 Tassin la Demi-Lune (FR)
(74) Mandataire: Chevalier, Renaud Philippe

(57) **Abrégé**

Procédé de cambrage des broches de contact électrique (8) d'un composant (6) fixées à un corps, disposées dans un plan principal, pour obtenir en partant de ce corps une base des broches (8) restant dans le plan principal, puis des cambrages des extrémités formés dans des plans transversaux, ce procédé comportant successivement une étape de positionnement d'une matrice inférieure (10) sous les broches (8), comprenant un appui inférieur ajusté sous la base des broches (8), et un profil inférieur adapté aux cambrages des extrémités à réaliser, puis la descente d'un serre-flanc (12) venant serrer la base des broches (8) au-dessus de l'appui inférieur, et enfin la descente d'une matrice supérieure (14) comprenant un profil supérieur venant sur le profil inférieur en serrant les extrémités des broches (8).

## Description

La présente invention concerne un procédé de cambrage des broches de contact électrique de composants, ainsi qu'un poste de cambrage mettant en œuvre un tel procédé.

Les composants électroniques comprenant un corps équipé de broches pour assurer les contacts électriques, sont de plus en plus utilisés. En particulier les véhicules automobiles comportent un nombre croissant de systèmes électroniques, notamment pour améliorer le contrôle de la combustion des moteurs thermiques ou pour commander des machines électriques de traction de véhicules hybrides ou électriques, afin de réduire la consommation d'énergie et les émissions de gaz polluants, pour aider à la conduite, pour l'automatiser, ou pour de nombreuses autres fonctions afin d'améliorer le confort et la sécurité.

En particulier les capteurs à effet hall sont utilisés dans des systèmes mécatroniques, pour mesurer ou contrôler des déplacements ou des positions. Ces composants peuvent être produits en grande série avec des broches disposées dans un même plan, formant un standard de fabrication. Il faut ensuite suivant les applications réaliser un cambrage et une coupe spécifiques des extrémités des broches, afin d'obtenir le meilleur positionnement de ces broches et de leurs points de contact sur un ensemble, permettant d'optimiser l'encombrement et la masse du système réalisé, ainsi que les coûts de ce système.

Toutefois des contraintes mécaniques trop élevées sur le composant, en particulier lors d'actions sur les broches, peuvent l'endommager en entraînant des rebuts qui seront détectés avant ou après le montage sur son ensemble, ce qui augmente les coûts. La mise en oeuvre d'un procédé de cambrage en grande série avec des cadences élevées, sans entraîner de risque de défaillance des composants, pose des problèmes de répétitivité et de fiabilité des opérations.

De plus le procédé de cambrage doit pouvoir s'adapter facilement à différents types de composants, ou à différentes formes de cambrage des broches d'un même type de composant, en permettant d'utiliser un poste de production flexible pouvant se configurer pour des utilisations variées afin de réduire les coûts.

La présente invention a notamment pour but d'éviter ces inconvénients de la technique antérieure.

Elle propose à cet effet un procédé de cambrage des broches de contact électrique d'un composant fixées à un corps, disposées dans un plan principal, pour obtenir en partant de ce corps une base des broches restant dans le plan principal, puis des cambrages des extrémités formés dans des plans transversaux, ce procédé étant remarquable en ce qu'il comporte successivement une étape de positionnement d'une matrice inférieure sous les broches, comprenant un appui inférieur ajusté sous la base des broches, et un profil inférieur adapté aux cambrages des extrémités à réaliser, puis la descente d'un serre-flanc venant serrer la base des broches au-dessus de l'appui inférieur, et enfin la descente d'une matrice supérieure comprenant un profil supérieur venant sur le profil inférieur en serrant les extrémités des broches.

Un avantage de ce procédé de cambrage est que le serrage préalable de la base des broches entre l'appui inférieur et le serre-flanc supérieur permet de maintenir en position cette base des broches, puis d'appliquer des contraintes sur le reste des broches pour réaliser leur cambrage, sans transmettre ces contraintes au corps du composant.

On peut de cette manière réaliser en grande série avec une cadence élevée un cambrage particulier de chaque broche des composants. En adaptant les supports du corps pour différents types de composants, ainsi que les deux matrices inférieure et supérieure, on réalise une machine standard pouvant passer différents types de composants, ce qui réduit les coûts.

Le procédé de cambrage selon l'invention, ainsi qu'un poste de cambrage mettant en œuvre ce procédé, peuvent comporter de plus une ou plusieurs des caractéristiques suivantes, qui peuvent être combinées entre elles.

Avantageusement, le procédé applique le serrage de la base des broches par le serre-flanc, par l'intermédiaire d'un ressort.

Avantageusement, le procédé réalise les mouvements de positionnement de la matrice inférieure, de descente du serre-flanc et de descente de la matrice supérieure, avec une même came déplacée par un actionneur.

L'invention a aussi pour objet un poste de cambrage des broches électriques d'un composant, mettant en œuvre un procédé comprenant l'une quelconque des caractéristiques précédentes, remarquable en ce qu'il comporte des guidages verticaux de la matrice inférieure, du serre-flanc et de la matrice supérieure.

Avantageusement, le poste comporte une liaison élastique entre un support coulissant verticalement, actionné par une motorisation, et le serre-flanc.

Dans ce cas, avantageusement la liaison élastique comporte des ressorts hélicoïdaux entourant des tiges de guidage.

Avantageusement, le poste comporte des cames réalisant les mouvements de positionnement de la matrice inférieure, de descente du serre-flanc et de descente de la matrice supérieure.

Dans ce cas, avantageusement le poste comporte une unique came réalisant les différents mouvements.

En particulier, la came peut être est disposée horizontalement en haut du poste de cambrage.

Avantageusement, le poste comporte un plateau tournant suivant un axe vertical, comprenant des supports de composants régulièrement espacés sur son contour extérieur.

L'invention sera mieux comprise et d'autres caractéristiques et avantages apparaîtront plus clairement à la lecture de la description ci-après donnée à titre d'exemple, en référence aux dessins annexés dans lesquels :
[Fig. 1] présente un poste de cambrage mettant en œuvre un procédé selon l'invention pour des composants disposés sur un plateau tournant ;
[Fig. 2] est une vue de détail de ce poste ;
[Fig. 3] est une vue de côté de ce poste ;
[Fig. 4] est une vue de côté présentant l'ajustement de la matrice inférieure sous les broches du composant ;
[Fig. 5] présente en perspective la descente du serre-flanc sur la base des broches ;
[Fig. 6] présente en vue de côté la descente du serre-flanc sur la base des broches ;
[Fig. 7] présente en perspective la descente de la matrice supérieure ;
[Fig. 8] présente en vue de côté, la descente de la matrice supérieure ; et
[Fig. 9] présente le dégagement des broches.

D'une manière générale le procédé de cambrage selon l'invention peut s'appliquer à tous types de composants, comprenant un corps et au moins une broche à cambrer.

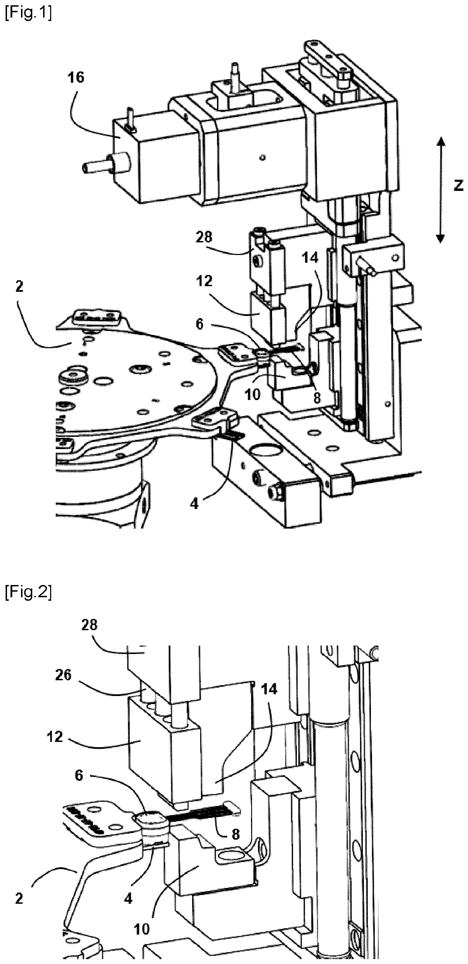

Les figures 1, 2 et 3 présentent un poste de cambrage disposé en face d'un plateau 2 tournant suivant un axe vertical, comportant six posages 4 répartis régulièrement sur son contour extérieur.

Chaque posage 4 forme un plan horizontal recevant le corps d'un composant 6, qui est calé en direction du centre du plateau 2 sur un appui latéral de mise en référence, afin de présenter une position définie. Chaque composant 6 présente trois broches parallèles 8, disposées dans un même plan horizontal, tournées radialement vers l'extérieur. Les extrémités des broches 8 sont reliées entre elles par un surmoulage en matière plastique, afin de les maintenir en position.

Par convention les côtés intérieur et extérieur du poste de cambrage, sont définis radialement par rapport au centre du plateau tournant 2.

Le poste de cambrage comporte plusieurs guidages verticaux suivant un axe Z, qui guident verticalement des éléments déplacés par un actionneur 16 disposé en partie supérieure, comprenant une matrice inférieure 8 venant sous les broches 6, un support 28 relié à un serre-flanc 12 venant au-dessus des broches près du corps, et une matrice supérieure 14 venant au-dessus des broches, à l'extérieur de ce serre-flanc.

Dans une première étape une rotation du plateau 2 d'un sixième de tour évacue un composant 6 après le formage de ses broches 8, puis présente un nouveau composant dans le poste de cambrage.

Les broches 8 du composant 6 doivent être cambrées de manière à former successivement en partant du corps, une base restant dans leur plan principal, puis dans un plan perpendiculaire passant par l'axe de ces broches, des profils des broches qui peuvent être identiques ou différents entre ces broches.

Dans cet exemple les cambrages identiques des trois broches 8 forment successivement un pli vers le bas suivant environ 80°, puis un pli vers l'extérieur laissant les extrémités de ces broches horizontales.

La matrice inférieure 10 comporte successivement en partant du corps du composant 6, une partie horizontale formant un appui inférieur 20 correspondant à la base des broches restant dans leur plan principal, puis un profil inférieur comprenant une partie inclinée vers le bas suivant un angle d'environ 80°, et ensuite une partie horizontale 22.

Le serre-flanc 12 comporte une base horizontale formant un appui supérieur 24, s'ajustant au-dessus de l'appui inférieur 20. Le serre-flanc 12 est relié à son support motorisé 28 suivant l'axe vertical Z, par un guidage vertical comprenant des ressorts hélicoïdaux 26 entourant des tiges de guidage, appliquant une pression vers le bas, donnant une petite élasticité entre ces deux parties.

La matrice supérieure 14 comporte un profil supérieur comprenant successivement en partant du côté intérieur, une partie inclinée vers le bas suivant un angle d'environ 80°, puis une partie horizontale 30, ce profil supérieur correspondant au profil inférieur de la matrice inférieure 10.

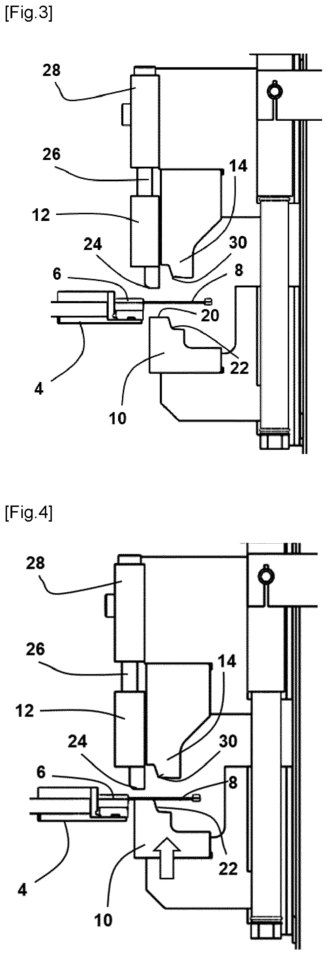

La figure 4 présente une étape suivante, comprenant la montée de la matrice inférieure 10 qui ajuste son appui inférieur 20 sous la base des broches 8.

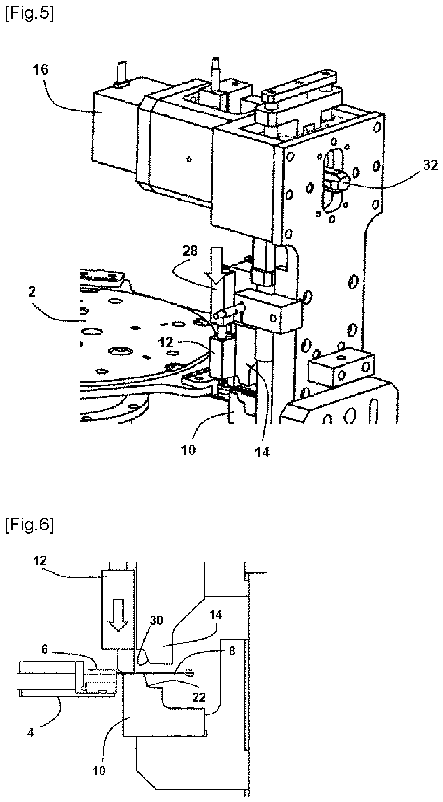

Les figures 5 et 6 présentent la descente du support 28 qui descend le serre-flanc 12, sa base 24 appliquant un effort de serrage sur les broches 8, ajusté dans certaines limites grâce à la liaison élastique donnée par les ressorts 26, permettant de limiter cet effort indépendamment des tolérances de l'épaisseur des broches. On obtient un maintien efficace des broches 8 en évitant de transmettre des efforts trop important à son corps, ce qui préserve l'intégrité du composant 6.

Avantageusement l'appui inférieur 20 de la matrice inférieure 20 et la base 24 du serre-flanc 12 comportent un traitement de surface adhérent permettant avec une pression modérée, de garantir l'absence de mouvement de la partie serrée des broches 8 lors des opérations de cambrage. De cette manière on évite des transmettre des efforts au boîtier, de traction sur les broches 8 notamment, qui pourraient endommager le composant.

L'actionneur 16 disposé en haut du poste de cambrage, comporte une came 32 coulissant horizontalement vers l'extérieur, comprenant différents profils qui actionnent les mouvements verticaux de la matrice inférieure 10, du serre-flanc 12 et de la matrice supérieure 14. On obtient par un seul mouvement rapide de la came 32, des actions coordonnées des différents éléments qui peuvent se faire à une cadence très élevée.

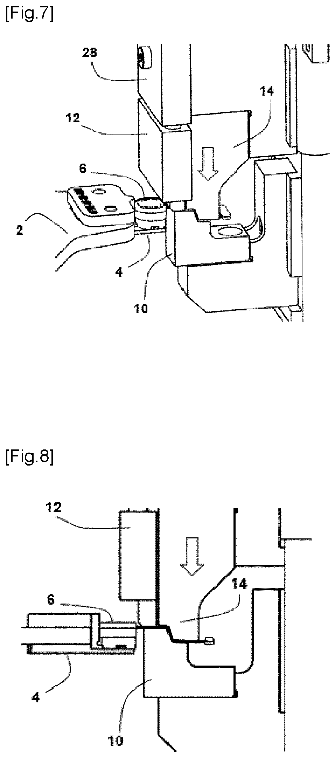

Les figures 7 et 8 présentent la descente de la matrice supérieure 14, son profil supérieur venant déformer les broches 8 en les appliquant sur le profil inférieur de la matrice inférieure 10, ces broches étant serrées entre ces deux profils.

On obtient un effort de déformation des broches métalliques 8, qui se transmet peu au corps du composant 6 grâce au serrage de la base de ces broches maintenant en position ces bases.

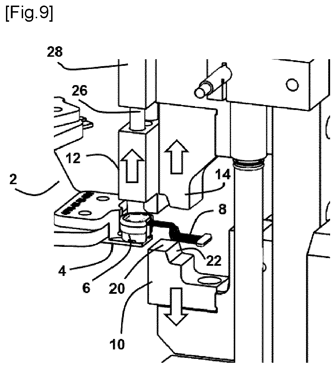

La figure 9 présente la descente de la matrice inférieure 10 et la remontée du serre-flanc 10 ainsi que de la matrice supérieure 14, ce qui libère le composant 6. Le plateau tournant 2 peut tourner suivant un pas pour présenter un nouveau composant 6.

Avantageusement les formes des profils inférieur et supérieur des matrices 10, 14, notamment leurs pentes, sont calculées pour tenir compte des déformations plastiques et élastiques des broches 8, ces dernières déformations élastiques entraînant un certain rappel en arrière des pliages après l'ouverture de ces matrices.

Avantageusement les profils inférieur et supérieur des matrices 10, 14 comportent des revêtements de surface adaptés aux caractéristiques des métaux des broches 8, afin d'obtenir le meilleur glissement évitant des arrachements de métal.

Le poste de cambrage est flexible, il peut effectuer facilement différents types de cambrage, ou recevoir différents types de composants, en adaptant les formes des profils des matrices inférieure 10 et supérieure 14, ainsi que les différentes courses verticales de ces éléments.

## Revendications

1. Procédé de cambrage des broches de contact électrique (8) d'un composant (6) fixées à un corps, disposées dans un plan principal, pour obtenir en partant de ce corps une base des broches (8) restant dans le plan principal, puis des cambrages des extrémités formés dans des plans transversaux, **caractérisé en ce qu'**il comporte successivement une étape de positionnement d'une matrice inférieure (10) sous les broches (8), comprenant un appui inférieur (20) ajusté sous la base des broches (8), et un profil inférieur (22) adapté aux cambrages des extrémités à réaliser, puis la descente d'un serre-flanc (12) venant serrer la base des broches (8) au-dessus de l'appui inférieur (20), et enfin la descente d'une matrice supérieure (14) comprenant un profil supérieur (30) venant sur le profil inférieur (22) en serrant les extrémités des broches (8), le procédé réalisant les mouvements de positionnement de la matrice inférieure (10), de descente du serre-flanc (12) et de descente de la matrice supérieure (14), avec une même came (32) déplacée par un actionneur (16).

2. Procédé de cambrage selon la revendication 1, **caractérisé en ce qu'**il applique le serrage de la base des broches (8) par le serre-flanc (12), par l'intermédiaire d'un ressort (26).

3. Poste de cambrage des broches électriques (8) d'un composant (6), mettant en œuvre un procédé selon l'une quelconque des revendications précédentes, **caractérisé en ce qu'**il comporte des guidages verticaux de la matrice inférieure (10), du serre-flanc (12) et de la matrice supérieure (14).

4. Poste de cambrage selon la revendication 3, **caractérisé en ce qu'**il comporte une liaison élastique (26) entre un support (28) coulissant verticalement, actionné par une motorisation, et le serre-flanc (12).

5. Poste de cambrage selon la revendication 4, **caractérisé en ce que** la liaison élastique (26) comporte des ressorts hélicoïdaux entourant des tiges de guidage.

6. Poste de cambrage selon l'une quelconque des revendications 3 à 5, **caractérisé en ce qu'**il comporte des cames réalisant les mouvements de positionnement de la matrice inférieure (10), de descente du serre-flanc (12) et de descente de la matrice supérieure (14).

7. Poste de cambrage selon la revendication 6, **caractérisé en ce qu'**il comporte une unique came (32) réalisant les différents mouvements.

8. Poste de cambrage selon la revendication 7, **caractérisé en ce que** la came (32) est disposée horizontalement en haut du poste de cambrage.

9. Poste de cambrage selon l'une quelconque des revendications 3 à 8, **caractérisé en ce qu'**il comporte un plateau tournant (2) suivant un axe vertical, comprenant des supports de composants (4) régulièrement espacés sur son contour extérieur.
